# EUROPEAN PATENT SPECIFICATION

(11) **EP 3 648 268 B1**
(45) Date of publication and mention of the grant of the patent: **15.07.2026**
(21) Application number: 18204097.2
(22) Date of filing: 02.11.2018
(51) Int. Cl.: G02F 1/01, G02F 1/225, G02F 1/35, H01S 5/50

(54) **OPTICAL AMPLIFIER DEVICE**
OPTISCHE VERSTÄRKERVORRICHTUNG
DISPOSITIF D'AMPLIFICATION OPTIQUE

(43) Date of publication of application: 06.05.2020
(73) Proprietor: Huawei Technologies Co., Ltd., Shenzhen, Guangdong 518129 (CN)
(72) Inventor: LEALMAN, Ian, 80992 Munich (DE); CHEN, Hongmin, 80992 Munich (DE)
(74) Representative: Gill Jennings & Every LLP

(56) References cited:
- US-A- 5 657 148
- US-A1- 2006 221 438
- US-A1- 2008 074 722
- US-A1- 2011 249 936

## Description

### BACKGROUND

This invention relates to optical amplifier devices, for example to reducing the size and improving the input power range of such devices.

High-performance and low-cost semiconductor optical amplifier (SOA) and variable optical attenuator (VOA) modules are used in applications such as large-capacity and high-speed optical access networks.

A conventional optical amplifier comprises a semiconductor block which has a front face or facet, a rear face or facet opposite to the front facet and an optical cavity formed therebetween. The cavity traditionally comprises an active layer interposed between layers of p- or n-type semiconductor material and defines a waveguide structure, which may be a ridge waveguide (RW) or a buried heterostructure (BH) waveguide. One or more coating layer(s), such as anti-reflection (AR) coatings, may be applied to the front and the rear facets. The bias current supplied to the device can be controlled so that there is gain along the cavity by stimulation of the active region of the device, resulting in amplification.

Compact modules are needed that can operate over distances of 0 to 40km without forward error correction (FEC), or 80km with FEC. In the current generation of modules this is achieved by using separately packaged SOA and VOA components. A discrete packaged SOA can be used to provide gain for long link lengths and a discrete packaged MEMS VOA attenuates the signal to prevent saturation and SOA patterning when the module is used with shorter fiber link lengths.

However, the use of two chips and separate packages is both too large and too expensive for the planned next generation modules. These modules ideally need a compact monolithic chip to perform both functions.

One approach is to replace the power detector in the receiver with an avalanche photodiode (APD). However, this approach can only cover a transmission distance of 30km without FEC (ER4 lite), which falls short of the 40km distance required in the ER4 standard.

It is desirable to produce an improved compact SOA device that can operate over a wide range of input powers.

US 5 657 148 A discloses a single-port, reflective, optical modulator with internal amplification.

### SUMMARY OF THE INVENTION

According to one aspect there is provided an optical amplifier device as in claim 1.

This invention provides a compact and low-cost device that can reach the 40km distance required in the ER4 standard using power detectors, which cannot be met using the conventional approach of using APDs with FEC in the receiver. It may also provide a solution capable of meeting the longer reach of 80km. As the device monolithically integrates an SOA chip with an element that acts as a VOA, the optical combiner, the optical amplifier and the phase change element may therefore be defined on a single substrate, which reduces the size of the device.

The optical amplifier device may comprise an optical splitter configured for splitting a signal received at the input port to the first and second optical paths. The optical splitter provides means for splitting the light signal from the input port to travel along the first and second optical paths so that the phase of the light travelling along the second path can be altered.

The optical amplifier device may comprise a first power detector for detecting a power of a signal received at the input port. The optical amplifier device may comprise a second power detector for detecting a power of a signal subsequent to the phase change element. The second power detector may be located so as to detect the power of a signal output from the optical combiner. This may allow for the power of the signal entering the SOA after the first and second optical paths have been recombined to be measured and compared to the power at the input port.

The optical amplifier device may comprise a controller configured to control the phase change element to implement a phase change in dependence on the power detected by the second power detector. The optical amplifier device may comprise a controller configured to control the phase change element to implement a phase change in dependence on the power detected by the first power detector. The phase of the light travelling along the second optical path may therefore be controlled based on the input port power to give a desired power at the input to the SOA section.

The controller may be configured to limit the power of a signal output from the optical combiner by controlling the phase change element to cause destructive interference at the optical combiner. In this way, the controller can limit the power of the signal input to the SOA by controlling the phase change element.

The optical combiner, the optical amplifier and the phase change element may be defined on a single substrate. This may reduce the size and cost of the device.

The phase change element may comprise an interferometer. The phase change element may comprise a Mach-Zehnder interferometer (MZI). The use of a MZI provides a convenient way of altering the phase of the light travelling along the second optical path to alter the amplitude of light at the input to an SOA section.

The optical amplifier device may comprise a heater for heating the phase change element to cause it to change the phase of a signal passing along the second optical path. The phase change element may be responsive to a change in electrical injection thereto to cause a change in the phase of a signal passing along the second optical path. The phase change element may be responsive to a change in voltage applied thereto to cause a change in the phase of a signal passing along the second optical path. These features provide effective ways of controlling the phase of the light travelling along the second optical path to result in constructive or destructive interference when the signals from the first and second paths are recombined.

The signal passing along the second optical path may be a data signal comprising symbols at a data rate and the phase change element may be configured to be controlled at a rate slower than half of the data rate. This may result in efficient operation of the optical amplifier device.

According to a second aspect there is provided a Mach-Zehnder interferometer configured to provide a variation in power to the input of a semiconductor optical amplifier. This may allow for the monolithic integration of an SOA chip with a VOA that can be defined on a single substrate, which can reduce the size of a SOA/VOA device.

According to a third aspect there is provided a semiconductor optical structure comprising: an input; a semiconductor optical amplifier for amplifying optical signals received at an amplifier input of the amplifier; and a gain controller between the input and the amplifier input, the gain controller comprising a Mach-Zehnder interferometer configured to change the phase of an optical signal received at the input and thereby change the power provided between the input and the amplifier input. This may allow for the monolithic integration of an SOA chip with a VOA that can be defined on a single substrate, which can reduce the size of a SOA/VOA device.

### BRIEF DESCRIPTION OF THE FIGURES

The present invention will now be described by way of example with reference to the accompanying drawings.

In the drawings:
Figure 1 shows a side view of an example of a semiconductor device.
Figures 2 shows a cross-section along A-A of Figure 1.
Figure 3 shows an example of an amplifier device according to the present invention.
Figure 4 shows another example of an amplifier device according to the present invention.

### DETAILED DESCRIPTION OF THE INVENTION

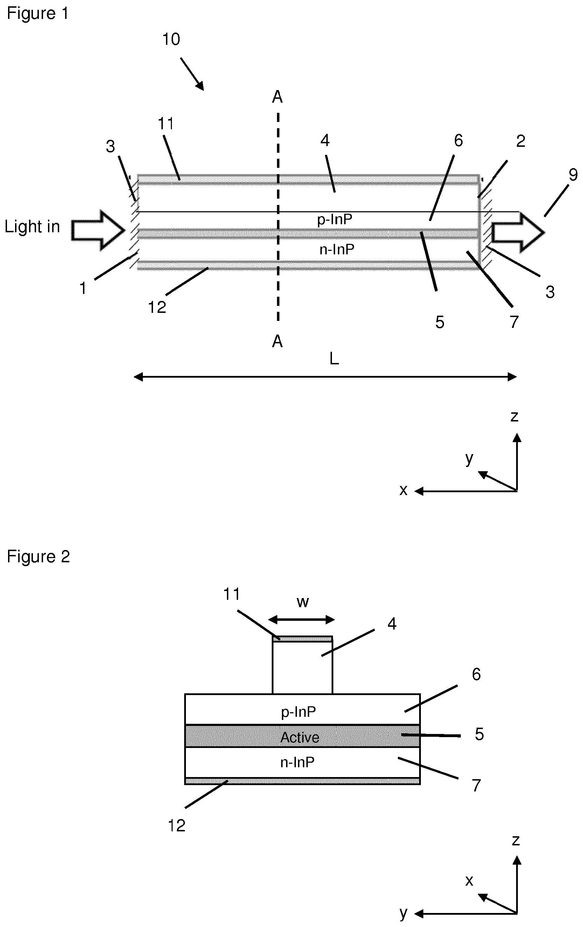

Figure 1 shows a side view of one example of a semiconductor optical amplifier 10. The device comprises a semiconductor block which has a front face or facet 1, a rear face or facet 2 opposite to the front face or facet and an optical cavity formed therebetween. The total length of the cavity is L. The cavity may be straight, as shown here, or the cavity may be inclined or at an angle relative to a direction perpendicular to the front facet.

It is preferable that the front and rear facets are aligned parallel to one another. The rear facet may be orthogonal to the length of the cavity. Preferably the front facet is orthogonal to the length of the cavity. An anti-reflection (AR) coating 3 can be applied to one or preferably both of the front and rear facets.

The cavity comprises an active layer 5 which may be may be interposed between layers of p- and n-type semiconductor material, shown at 6 and 7 respectively. The cavity may also comprise additional semiconductor outrigger layers beneath layers 5, 6 and 7. In this example, the semiconductor layers are made from InP. However, other semiconductor materials, such as GaAs, may be used. The material forming the cavity may be selectively doped in the region of the p- and n-type layers 6, 7. The optical cavity also comprises an etched waveguide layer 4, which provides lateral waveguiding.

The device has a common n electrode 12 on one side of the cavity, which may be adjacent to the floor of the cavity, and another electrode 11 on the opposite side of the cavity. The application of a forward bias voltage to the electrodes of a section, such that the section acts as a gain section, causes light emission to be stimulated from that section of the cavity by applying a current across the electrodes. The application of a reverse bias voltage to the electrodes, such that the cavity acts as an absorber section, causes light to be absorbed in that section of the cavity.

Light is emitted from the end of the waveguide at the rear face of the SOA device, shown at 9.

Figure 2 shows a vertical section along A-A of Figure 1. At each point along the length of the cavity, the waveguide layer 4 has a width w defined transverse to the length of the cavity. The width of the waveguide may be constant or it may vary along the length of the cavity. In the vertical section, the active layer 5, and the semiconductor layers 6 and 7 all form part of the waveguide and guide the light in the vertical direction. The waveguide is thus formed by any layer or combination of layers that have a higher refractive index than the surrounding substrate and cladding layers, allowing the layer(s) to provide optical guiding.

The waveguide also has an optical confinement factor, Γ (Gamma). The optical confinement factor of a waveguide is defined as the proportion of the light in the guided mode which is contained within the active region or waveguide core. i.e. the section of the structure that generates the optical gain in the SOA device.

The waveguide may be a ridge waveguide. The ridge waveguide may be created by etching parallel trenches in the material either side of the waveguide layer 4 to create an isolated projecting strip, typically less than 5 µm wide and several hundred µm long. A material with a lower refractive index than the waveguide material can be deposited at the sides of the ridge to guide injected current into the ridge. Alternatively, the ridge may be surrounded by air on the three sides that are not in contact with the substrate beneath the waveguide. The ridge provides the lateral waveguiding, since the other layers in the structure above the active layer have a higher index than the air or passivation layers (typically silica or silicon nitride) in the etched channel regions.

Light may therefore enter the cavity at the front face 1 and be amplified along the cavity before exiting the SOA device at the rear face 2, shown at 9.

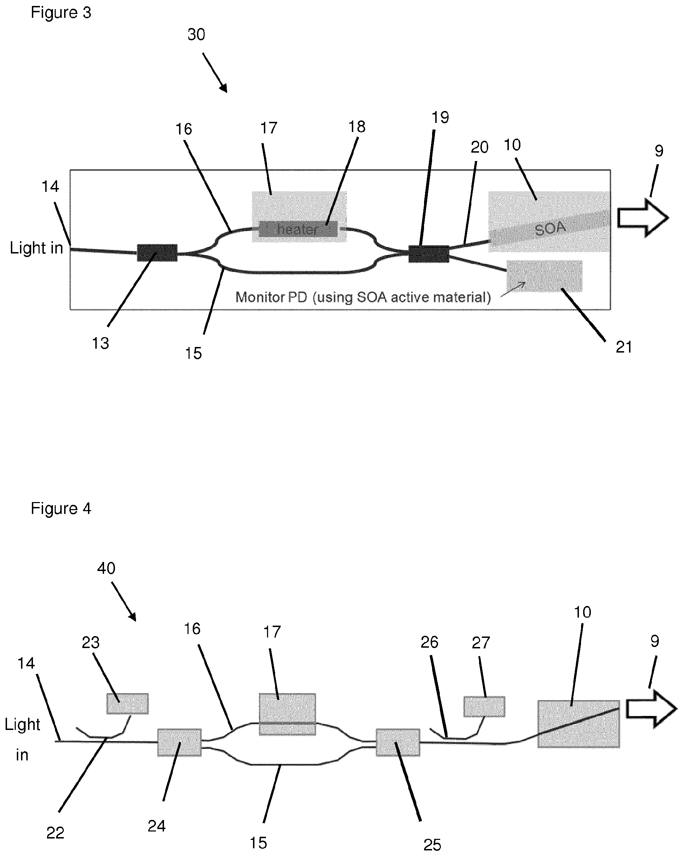

To control the input power of the light entering the SOA at the front face 1, the device according to the present invention monolithically integrates an SOA chip with a structure as described with reference to Figure 3 or Figure 4 which acts as a variable optical attenuator (VOA). This structure may include two optical paths, one of which has on it a component which acts as a phase change element to adjust the phase of light passing along that optical path. The phase change element may be an interferometer which can act as a phase modulator. In the examples described below, the phase change element is a Mach-Zehnder Interferometer (MZI). The device can tune the phase of the signal on one of the paths to result in constructive or destructive interference when the signals travelling along the two separate paths are recombined. The recombined signal can then be used as an input to the SOA. As a result, the amplitude of light entering the input to the SOA section 10 can be varied and limited if desired.

Figure 3 shows one embodiment of an optical amplifier device 30 according to the present invention which uses a 1x2 MMI (multi-mode interference) coupler 13 to split the light signal received at the input port 14 of the device along a first optical path 15 and a second optical path 16. Along the second optical path 16 is a Mach-Zehnder interferometer 17. A heater 18 allows the MZI to be controlled to adjust the phase of a light signal passing through the MZI by a desired amount. The first and second paths are then recoupled by 2x2 MMI output coupler 19. The light travelling along the second optical path, through the MZI, undergoes a phase shift which interferes constructively or destructively with the light from the first optical path when the paths are recoupled at the 2x2 MMI output coupler 19. The bar port of the 2x2 MMI coupler is used to monitor the power of the signal input to the SOA 10 using a detector 21, which in this example is a photodiode.

The photodiode 21 may be fabricated using a separate absorber layer or may be formed using the same active material as the SOA. It is well known that if a zero or reverse bias voltage is applied to waveguide material the SOA active region will absorb light rather than generate it. In this configuration, the SOA can be used as a photodiode for wavelengths from around the band edge and shorter but, as for any photodiode, it will be low loss and essentially transparent for wavelengths significantly longer than the band edge. Using the same active region to produce the gain and photodiode regions of the device has an advantage in terms of device fabrication, since it means that a separate growth steps are not required to form the photodiode.

The device may also comprise a controller (not shown) configured to control the MZI to implement a degree of phase change in dependence on the power detected by the power detector 21. Thus the phase change of the light travelling along the second path can be controlled to achieve a desired power input to the SOA. In this way, the controller may be configured to limit the power of the signal input to the SOA at a certain maximum value by controlling the MZI.

The use of a slow speed MZI in conjunction with an SOA 10 therefore provides the amplifier with automatic gain control by controlling the amplitude of light entering the SOA at the input facet 1.

As the device monolithically integrates an SOA chip with a VOA formed from a MZI, the optical splitter 3, optical combiner 19, the optical amplifier 10 and the phase change element 17 may therefore be defined on a single substrate, which reduces the size of the device.

The phase shift of light entering and exiting the MZI 17 can be controlled thermally, using a heater 18 as described above. The MZI may also be responsive to by electrical injection thereto, or responsive to a voltage applied thereto to adjust the phase of the signal passing along the second optical path to move from constructive to destructive interference, or via another mechanism.

In the case where a heater is to be used to provide the phase control in the MZI, it is also preferable that the heater section is undercut to remove the InP or other semiconductor below the waveguide layers to reduce the power needed to locally heat the waveguide to provide the required phase change.

Figure 4 shows another embodiment of an amplifier device according to the present invention. In this embodiment, input and output taps 22, 26 are used to perform power monitoring and two 1x2 MMIs 24, 25 are used to perform the power splitting and combination around the phase control element 17 on the second optical path 16.

An input power detector 23 at the input tap 22 detects the power of a signal received at the input port 14 and an output power detector 27 at the output tap 26 detects the power of the signal at a position between the recoupler 25 and the input to the SOA 10.

As for the embodiment of Figure 3, the device may also comprise a controller (not shown) configured to control the MZI to implement a degree of phase change in dependence on the power detected by the output power detector 27 and limit the power input to the SOA. The controller may also control the MZI in dependence on the power detected by the input power detector 23.

The output taps need to remove only a small portion of the light to minimise the VOA losses in its state of minimum attenuation. In the case of minimum attenuation the VOA losses should be of the order of 1dB, while in the maximum attenuation case, for a QSFP28 module targeting around 80km reach, would be around 20dB or more.

As for the device of Figure 3, in the embodiment of Figure 4 the optical amplifier 10 and the phase control element 17 are monolithically integrated and can therefore be defined on a single substrate, which reduces the size of the device.

The embodiment of Figure 4 uses 1x2 MMI to split and couple the optical paths. Alternatively, y-junctions may be used to perform the power splitting and combination around the phase control element on the second optical path.

At start up of the device, the phase change element may be set to minimize the output power (maximize the loss) then ramp up the output power. The device may use power detectors with a lookup table to determine the safe working power range of the SOA.

This invention provides a compact and low-cost method of realizing ER4 modules that can operate over a wider dynamic range of input powers. Furthermore, these modules may reach not only the full 40km distance using power detectors without FEC, which cannot be met using the conventional approach of APDs with FEC in the receiver, but may also provide a solution capable of meeting the longer reach of 80km that no other suppliers have proposed a solution for.

Although the examples above describe a SOA device which has a ridge waveguide, the present invention can also be applied to devices having a buried heterostructure waveguide.

The waveguide may be inclined relative to a direction perpendicular to the front face of the cavity such that the waveguide slopes upwards towards the rear face. The waveguide may be inclined relative to the cavity length by an angle of 5°, 10°, 15° or 20°.

The optical amplifier structure may be integrated with another optically functional structure.

## Claims

1. A monolithically integrated semiconductor optical amplifier device (30, 40), the device comprising:
an input port (14) for receiving an optical signal;
an optical combiner (19, 25);
an optical amplifier (10) for amplifying a signal output from the optical combiner (20) to form an amplified signal at an output (9) of the optical amplifier (10);
a first optical path (15) between the input (14) and the optical combiner (19, 25);
a second optical path (16) between the input (14) and the optical combiner (19, 25); and
a phase change element (17) located in the second optical path (16) for changing the phase of a signal passing along the second optical path (16), the phase change element (17) being controllable so as to cause constructive and/or destructive optical interference at the optical combiner (19) between signals from the first (15) and second (16) optical paths and thereby alter the gain of the optical amplifier device (10);
the device further comprising a first power detector (23) for detecting a power of a signal received at the input port (14) and an output power detector (27) for detecting a power of a signal at the input to the optical amplifier (10);
wherein the optical combiner (19, 25), the optical amplifier (10), the phase change element (17), the first power detector (23) and the output power detector (27) are defined on a single substrate:
wherein the signal passing along the second optical path (16) is a data signal comprising symbols at a data rate and the phase change element (17) is configured to be controlled at a rate slower than half of the data rate.

2. A monolithically integrated semiconductor optical amplifier device (30, 40) as claimed in claim 1, wherein the second power detector (21, 27) is located so as to detect the power of a signal output from the optical combiner (19, 25).

3. A monolithically integrated semiconductor optical amplifier device (30, 40) as claimed in claim 1 or claim 2, comprising a controller (18) configured to control the phase change element (17) to implement a phase change in dependence on the power detected by the second power detector (21, 27).

4. A monolithically integrated semiconductor optical amplifier device (30, 40) as claimed in any of claims 1 to 3, comprising a controller configured to control the phase change element (17) to implement a phase change in dependence on the power detected by the first power detector (23).

5. A monolithically integrated semiconductor optical amplifier device (30, 40) as claimed in claim 3 or claim 4, wherein the controller is configured to limit the power of a signal output from the optical combiner (19, 25) by controlling the phase change element to cause destructive interference at the optical combiner (19, 25).

6. A monolithically integrated semiconductor optical amplifier device (30, 40) as claimed in any preceding claim, wherein the phase change element (17) comprises an interferometer.

7. A monolithically integrated semiconductor optical amplifier device (30, 40) as claimed in any preceding claims, wherein the phase change element (17) comprises a Mach-Zehnder interferometer.

8. A monolithically integrated semiconductor optical amplifier device (30, 40) as claimed in any preceding claim, wherein the optical amplifier device (30, 40) comprises a heater (18) for heating the phase change element (17) to cause it to change the phase of a signal passing along the second optical path (16).

9. A monolithically integrated semiconductor optical amplifier device (30, 40) as claimed in any preceding claim, wherein the phase change element (17) is responsive to a change in electrical injection thereto to cause a change in the phase of a signal passing along the second optical path (16).

10. A monolithically integrated semiconductor optical amplifier device (30, 40) as claimed in any preceding claim, wherein the phase change element (17) is responsive to a change in voltage applied thereto to cause a change in the phase of a signal passing along the second optical path (16).

## Patentansprüche

1. Monolithisch integrierte optische Halbleiterverstärkervorrichtung (30, 40), wobei die Vorrichtung Folgendes umfasst:
einen Eingabeanschluss (14) zum Empfangen eines optischen Signals;
einen optischen Kombinierer (19, 25);
einen optischen Verstärker (10) zum Verstärken eines Signals, das aus dem optischen Kombinierer (20) ausgegeben wird, um ein verstärktes Signal an einer Ausgabe (9) des optischen Verstärkers (10) zu bilden;
einen ersten optischen Pfad (15) zwischen der Eingabe (14) und dem optischen Kombinierer (19, 25);
einen zweiten optischen Pfad (16) zwischen der Eingabe (14) und dem optischen Kombinierer (19, 25); und
ein Phasenänderungselement (17), das sich in dem zweiten optischen Pfad (16) befindet, zum Ändern der Phase eines Signals, das entlang des zweiten optischen Pfades (16) verläuft, wobei das Phasenänderungselement (17) steuerbar ist, um eine konstruktive und/oder eine destruktive optische Interferenz an dem optischen Kombinierer (19) zwischen Signalen aus dem ersten (15) und dem zweiten (16) optischen Pfad zu veranlassen und dadurch die Verstärkung der optischen Verstärkervorrichtung (10) zu verändern;
wobei die Vorrichtung ferner einen ersten Leistungsdetektor (23) zum Detektieren einer Leistung eines Signals, das an dem Eingabeanschluss (14) empfangen wird, und einen Ausgabeleistungsdetektor (27) zum Detektieren einer Leistung eines Signals an der Eingabe zu dem optischen Verstärker (10) umfasst;
wobei der optische Kombinierer (19, 25), der optische Verstärker (10), das Phasenänderungselement (17), der erste Leistungsdetektor (23) und der Ausgabeleistungsdetektor (27) auf einem einzigen Substrat definiert sind;
wobei das Signal, das entlang des zweiten optischen Pfades (16) verläuft, ein Datensignal ist, das Symbole mit einer Datenrate umfasst, und das Phasenänderungselement (17) dazu konfiguriert ist, mit einer Rate gesteuert zu werden, die langsamer als eine Hälfte der Datenrate ist.

2. Monolithisch integrierte optische Halbleiterverstärkervorrichtung (30, 40) nach Anspruch 1, wobei sich der zweite Leistungsdetektor (21, 27) dazu befindet, die Leistung eines Signals zu detektieren, das aus dem optischen Kombinierer (19, 25) ausgegeben wird.

3. Monolithisch integrierte optische Halbleiterverstärkervorrichtung (30, 40) nach Anspruch 1 oder Anspruch 2, umfassend eine Steuerung (18), die dazu konfiguriert ist, das Phasenänderungselement (17) zu steuern, um eine Phasenänderung in Abhängigkeit von der Leistung, die durch den zweiten Leistungsdetektor (21, 27) detektiert wird, umzusetzen.

4. Monolithisch integrierte optische Halbleiterverstärkervorrichtung (30, 40) nach einem der Ansprüche 1 bis 3, umfassend eine Steuerung, die dazu konfiguriert ist, das Phasenänderungselement (17) zu steuern, um eine Phasenänderung in Abhängigkeit von der Leistung, die durch den ersten Leistungsdetektor (23) detektiert wird, umzusetzen.

5. Monolithisch integrierte optische Halbleiterverstärkervorrichtung (30, 40) nach Anspruch 3 oder Anspruch 4, wobei die Steuerung dazu konfiguriert ist, die Leistung eines Signals, das aus dem optischen Kombinierer (19, 25) ausgegeben wird, durch Steuern des Phasenänderungselements zu begrenzen, um die destruktive Interferenz an dem optischen Kombinierer (19, 25) zu veranlassen.

6. Monolithisch integrierte optische Halbleiterverstärkervorrichtung (30, 40) nach einem der vorhergehenden Ansprüche, wobei das Phasenänderungselement (17) ein Interferometer umfasst.

7. Monolithisch integrierte optische Halbleiterverstärkervorrichtung (30, 40) nach einem der vorhergehenden Ansprüche, wobei das Phasenänderungselement (17) ein Mach-Zehnder-Interferometer umfasst.

8. Monolithisch integrierte optische Halbleiterverstärkervorrichtung (30, 40) nach einem der vorhergehenden Ansprüche, wobei die optische Verstärkervorrichtung (30, 40) eine Heizung (18) zum Heizen des Phasenänderungselements (17) umfasst, um es dazu zu veranlassen, die Phase eines Signals zu ändern, das entlang des zweiten optischen Pfades (16) verläuft.

9. Monolithisch integrierte optische Halbleiterverstärkervorrichtung (30, 40) nach einem der vorhergehenden Ansprüche, wobei das Phasenänderungselement (17) auf eine Änderung in einer elektrischen Einspeisung darin reagiert, um eine Änderung in der Phase eines Signals zu veranlassen, das entlang des zweiten optischen Pfades (16) verläuft.

10. Monolithisch integrierte optische Halbleiterverstärkervorrichtung (30, 40) nach einem der vorhergehenden Ansprüche, wobei das Phasenänderungselement (17) auf eine Änderung in einer darauf angewandten Spannung reagiert, um eine Änderung in der Phase eines Signals zu veranlassen, das entlang des zweiten optischen Pfades (16) verläuft.

## Revendications

1. Dispositif d'amplification optique à semi-conducteur intégré monolithiquement (30, 40), le dispositif comprenant :
un port d'entrée (14) destiné à recevoir un signal optique ;
un combinateur optique (19, 25) ;
un amplificateur optique (10) destiné à amplifier un signal issu du combinateur optique (20) pour former un signal amplifié au niveau d'une sortie (9) de l'amplificateur optique (10) ;
un premier trajet optique (15) entre l'entrée (14) et le combinateur optique (19, 25) ;
un second trajet optique (16) entre l'entrée (14) et le combinateur optique (19, 25) ; et
un élément de changement de phase (17) situé dans le second trajet optique (16) destiné à changer la phase d'un signal passant le long du second trajet optique (16), l'élément de changement de phase (17) pouvant être commandé de manière à provoquer une interférence optique constructive et/ou destructive au niveau du combinateur optique (19) entre des signaux provenant du premier (15) et du second (16) trajet optique, et ainsi modifier le gain du dispositif d'amplification optique (10) ;
le dispositif comprenant également un premier détecteur de puissance (23) destiné à détecter la puissance d'un signal reçu au niveau du port d'entrée (14) et un détecteur de puissance de sortie (27) destiné à détecter la puissance d'un signal au niveau de l'entrée de l'amplificateur optique (10) ;
dans lequel le combinateur optique (19, 25), l'amplificateur optique (10), l'élément de changement de phase (17), le premier détecteur de puissance (23) et le détecteur de puissance de sortie (27) sont définis sur un substrat unique ;
dans lequel le signal passant le long du second trajet optique (16) est un signal de données comprenant des symboles à un débit de données et l'élément de changement de phase (17) est configuré pour être commandé à un débit inférieur à la moitié du débit de données.

2. Dispositif d'amplification optique à semi-conducteur intégré monolithiquement (30, 40) selon la revendication 1, dans lequel le second détecteur de puissance (21, 27) est situé de manière à détecter la puissance d'un signal de sortie provenant du combinateur optique (19, 25).

3. Dispositif d'amplification optique à semi-conducteur intégré monolithiquement (30, 40) selon la revendication 1 ou la revendication 2, comprenant un dispositif de commande (18) configuré pour commander l'élément de changement de phase (17) pour mettre en œuvre un changement de phase en fonction de la puissance détectée par le second détecteur de puissance (21, 27).

4. Dispositif d'amplification optique à semi-conducteur intégré monolithiquement (30, 40) selon l'une quelconque des revendications 1 à 3, comprenant un dispositif de commande configuré pour commander l'élément de changement de phase (17) pour mettre en œuvre un changement de phase en fonction de la puissance détectée par le premier détecteur de puissance (23).

5. Dispositif d'amplification optique à semi-conducteur intégré monolithiquement (30, 40) selon la revendication 3 ou la revendication 4, dans lequel le dispositif de commande est configuré pour limiter la puissance d'un signal issu du combinateur optique (19, 25) en commandant l'élément de changement de phase de manière à provoquer une interférence destructive au niveau du combinateur optique (19, 25).

6. Dispositif d'amplification optique à semi-conducteur intégré monolithiquement (30, 40) selon une quelconque revendication précédente, dans lequel l'élément de changement de phase (17) comprend un interféromètre.

7. Dispositif d'amplificateur optique à semi-conducteur intégré monolithiquement (30, 40) selon l'une quelconque des revendications précédentes, dans lequel l'élément de changement de phase (17) comprend un interféromètre de Mach-Zehnder.

8. Dispositif d'amplification optique à semi-conducteur intégré monolithiquement (30, 40) selon une quelconque revendication précédente, dans lequel le dispositif d'amplification optique (30, 40) comprend un élément chauffant (18) destiné à chauffer l'élément de changement de phase (17) pour provoquer un changement de phase d'un signal passant le long du second trajet optique (16).

9. Dispositif d'amplification optique à semi-conducteur intégré monolithiquement (30, 40) selon une quelconque revendication précédente, dans lequel l'élément de changement de phase (17) est sensible à un changement d'injection électrique qui lui est appliqué, de manière à provoquer un changement de phase d'un signal passant le long du second trajet optique (16).

10. Dispositif d'amplification optique à semi-conducteur intégré monolithiquement (30, 40) selon une quelconque revendication précédente, dans lequel l'élément de changement de phase (17) est sensible à un changement de tension qui lui est appliqué, de manière à provoquer un changement de phase d'un signal passant le long du second trajet optique (16).
